# EUROPEAN PATENT SPECIFICATION

(11) **EP 0 221 523 B1**
(45) Date of publication and mention of the grant of the patent: **03.08.1994**
(21) Application number: 86115170.2
(22) Date of filing: 01.11.1986
(51) Int. Cl.: H01L 31/06, H01L 31/02

(54) **Semiconductor device**
Halbleitervorrichtung
Dispositif à semi-conducteur

(30) Priority: 05.11.1985 JP 247463/85; 14.11.1985 JP 255681/85; 30.04.1986 JP 99939/86
(43) Date of publication of application: 13.05.1987
(60) Divisional application: 92104633.0
(73) Proprietor: KANEGAFUCHI KAGAKU KOGYO KABUSHIKI KAISHA, Kita-ku Osaka-shi Osaka-fu 530 (JP)
(72) Inventor: Yamagishi, Hideo, Tarumi-ku Kobe-shi Hyogo-ken (JP); Kondo, Masataka, Kita-ku Kobe-shi Hyogo-ken (JP); Nishimura, Kunio, Yamashina-ku Kyoto-shi Kyoto-fu (JP); Hiroe, Akihiko, Tarumi-ku Kobe-shi Hyogo-ken (JP); Asaoka, Keizou, Tarumi-ku Kobe-shi Hyogo-ken (JP); Tsuge, Kazunori, Tarumi-ku Kobe-shi Hyogo-ken (JP); Tawada, Yoshihisa, Kita-ku Kobe-shi Hyogo-ken (JP); Yamaguchi, Minori, Akashi-shi Hyogo-ken (JP)
(74) Representative: Türk, Gille, Hrabal, Leifert

(56) References cited:
- EP-A- 0 070 509
- EP-A- 0 093 514
- EP-A- 0 099 720
- GB-A- 2 137 810
- US-A- 4 379 943
- US-A- 4 531 015
- JOURNAL OF APPLIED PHYSICS, vol. 56, no. 2, July 1984, pages 538-542; New York, US - K. LIM et al.: "A novel structure, high conversion efficiency p-SiC/graded p-SiC/i-Si/n-Si metal substrate-type amorphous silicon solar cell"
- PATENT ABSTRACTS OF JAPAN, vol. 8, no. 185 (E-262)(1622), August 24, 1984 & JP-A-59 075 682
- PATENT ABSTRACTS OF JAPAN, vol. 7, no. 154 (E-185)(1299), July 6, 1983 & JP-A-58 064 070
- PATENT ABSTRACTS OF JAPAN, vol. 6, no. 32 (E-96)(910), February 25, 1982 & JP-A-56 150 876

## Description

The present invention relates to a semiconductor device, and more particularly to a semiconductor device comprising a photovoltaic device having high open-circuit voltage under light irradiation or a photovoltaic device of which photoelectric conversion efficiency is improved.

Hitherto, as a material for photoelectric converters such as solar cells, there has been used a semiconductor material comprising amorphous semiconductor such as a-Si:H, a-Si₁₋ₓ:C_{X}:H, a-Si₁₋ₓGeₓ:H, a-Si:F:H, a-Si₁₋ₓNₓH, a-Ge:H, a-Si₁₋ₓGeₓ:F:H, a-Si:H, µc-Si:H, µc-Si₁₋ₓGeₓ:H (wherein x satisfies the relationship of 0<x<1) or semiconductor material containing partially these amorphous semiconductors.

A conventional solar cell has a laminated structure of pin, nip, pinpin... or nipnip... obtained by depositing in order the same kind of amorphous semiconductors or different kinds of amorphous semiconductors having a wide energy gap only in their doping layer. The density of dopant in p-type or n-type layer is uniform throughout a direction of the thickness of the layer except the distribution of dopant due to thermal diffusion during and after the production of the device, and it is usually 0.01 to 5 atom %.

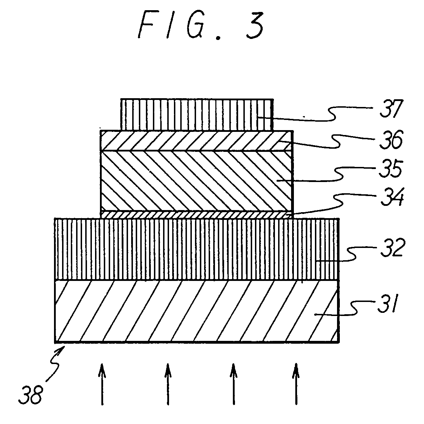

Fig. 3 shows a semiconductor device employed in a conventional solar cell using pin-type semiconductor of triple layer construction. In Fig. 3, numeral 31 is a glass substrate whereon a transparent electrode 32 is attached. On the transparent electrode 32, there are formed a p-type semiconductor layer 34, i-type semiconductor layer 35 and n-type semiconductor layer 36 in order. Further, on the n-type semiconductor layer 36, there is formed an electrode 37. The semiconductor device 38 consists of a glass substrate 31, a transparent electrode 32, a p-type semiconductor layer 34, an i-type semiconductor layer 35, a n-type semiconductor layer 36 and an electrode 37.

In the above semiconductor device 38, light enters the glass substrate 31 along a direction of arrows in Fig. 9, is transmitted through the glass substrate 31 and the electrode 32, and then irradiates the p-type semiconductor layer 34, i-type semiconductor layer 35 and n-type semiconductor layer 36. By this irradiation, pairs of electrons and holes are generated in each semiconductor layer 34, 35 and 36. Then, electrons are collected in the n-type layer and holes are collected in the p-type layer and thereby, there are generated positive charges at the transparent electrode 32 and negative charges at the electrode 37. Thus, a photoelectric conversion is carried out to give the semiconductor device 38 a function as a photo cell.

However, a semiconductor device having the above construction has a drawback that it cannot increase a voltage value at open-circuit condition (hereinafter referred to as Voc) during the irradiation of light, since the semiconductor device has a limitation in increasing a built-in field.

In case of using the above devices, for example, when an electromotive force more than Voc is required, a plurality of devices can be connected in series in order to remove the above drawback. Even in that case, however, the number of series connections can be decreased if Voc per one device can be improved. Further, performance of devices can be expected to be remarkably improved by making an area per one semiconductor layer large, even in case that the total area of all devices is limited.

As a result of vigorous investigation while taking notice of a device construction of a semiconductor, we inventors have discovered a semiconductor device having higher Voc and electric current (operating electric current) at a specific voltage than conventional semiconductor devices without increasing the number of series connections and total area of all devices, and have completed a semiconductor device of the present invention.

Furthermore, in the conventional semiconductor device, it is generally known that a contact resistance between a p-type semiconductor layer and an electrode at the side of a p-layer and between an n-type semiconductor layer and an electrode at the side of n-layer becomes small as a value of impurity density becomes large. It is desirable to make this contact resistance small, because it deteriorates a fill factor of a photovoltaic device when the p-type semiconductor layer and n-type semiconductor layer are used as a photovoltaic device such as a solar cell. Therefore, from this point of view, it is desirable to increase the impurity density. However, if the impurity density of the n-type and p-type semiconductor layer become too large, there is caused a problem that the characteristic as a photovoltaic device deteriorates due to the large absorption loss of light in such parts that contain impurity.

The document US-A-4,531,015 relates to thin film solar cells and more specifically to amorphous silicon solar cells in which a nitrogen compensated intrinsic interlayer is provided between the front face p-type layer and the intrinsic layer. This a-Si:H layer contains 2 to 5 atom% of nitrogen. Nitrogen-doped a-Si:H is also used as a n-type layer which is alloyed with nitrogen in a silicon to nitrogen atomic ratio of from about 3:1 to about 11:2.

GB-A-2 137 910 discloses an amorphous silicon solar cell in which the p-layer is divided into two regions having different bandgaps. The resistivity of the p-layer adjacent to the i-layer is lower than the resistivity of the p-layer adjacent to the electrode.

It is the object of the present invention to provide a semiconductor device having high open-circuit voltage under light irradiation, and a semiconductor device of which the photoelectric conversion efficiency is improved.

This object is solved by a semiconductor device as defined in claim 1.

In the present invention, the term of "pin-type or nip-type device means a device comprising at least each one layer of (A) one conductivity type layer, (B) non-doped or slightly doped substantially intrinsic layer and (C) a conductive type opposite said conductive layer; and at least two electrodes. Further, it naturally includes a device comprising a plurarity of p, i and/or n layers; and a tandem type device wherein a unit of pin or nip is stacked.
Fig. 1 is a schematic diagram of a semiconductor device comprising a pin-type semiconductor layer and explaining the present invention;
Fig. 2 is a schematic diagram of a semiconductor device comprising a nip-type semiconductor layer and explaining the present invention; and
Fig. 3 is a sectional view of a conventional semiconductor device.

The term "amorphous-containing semiconductor device of pin-type or nip-type" generally means such a device that has a construction used in a-Si photovoltaic devices or photodiodes. Any semicondcutor device can be employed in the present invention as far as it satisfies this condition.

Further, the term "amorphous-containing semiconductor" means (1) a semiconductor composed solely of amorphous, (2) a semiconductor wherein microcrystal semiconductor is dispersed in amorphous semiconductor, or (3) a semiconductor wherein amorphous semiconductor is dispersed in large granular crystal semiconductor. These semiconductors are generally called to be non-single crystalline semiconductors.

There can be preferably employed boron-doped a-Si:H, a-Si₁₋ₓCₓ:H, or the like as p-type amorphous-containing semiconductor layer (hereinafter referred to as p-type layer); a-Si:H, a-Si₁₋ₓGeₓ:H, or the like as i-type amorphous-containing semiconductor layer (hereinafter referred to as i-type layer); phosphorus-doped a-Si:H, µc-Si:H, or the like as n-type amorphous-containing semiconductor layer (hereinafter referred to as n-type layer), which are used in conventional amorphous semiconductor photovoltaic devices or photodiodes.

As an interlayer in the present invention having larger electrical resistivity than a semiconductor layer which adjoins the interlayer, there can preferably be employed, in general, such a layer of which conductivity is not more than one-tenth of that of i-type layer (the conductivity of i-type layer is, for example, about 5 x 10⁻⁹ (Ω·cm)⁻¹ in the case of a-Si:H), and not more than one-hundredth of that of p-type or n-type layer adjoining the interlayer. Concrete examples of the above interlayer are Si₁₋ₓCₓ:X:Y, or Si₁₋ₓOₓ:X:Y (wherein x satisfies the relationship of 0 <x <1; X is H, Cℓ, F or Br; and Y is H, Cℓ, F or Br) of which influence upon short circuit current, curve factor and other factors is small; and an insulator which does not have undesired influence upon the other layers. Among these examples, Si₁₋ₓCₓ:H (wherein x satisfies the relationship of 0 <x <1) is particularly preferable in the point that it can remarkably improve Voc.

The electrical resistivity of the above semiconductors can be easily adjusted by varying a composition rate, i.e. the value of "x" or the amount of dopant in the above-mentioned formulas. In the present invention, for instance, 0.001 to 5 atm % of trivalent or pentavalent elements such as P or B is used as a dopant.

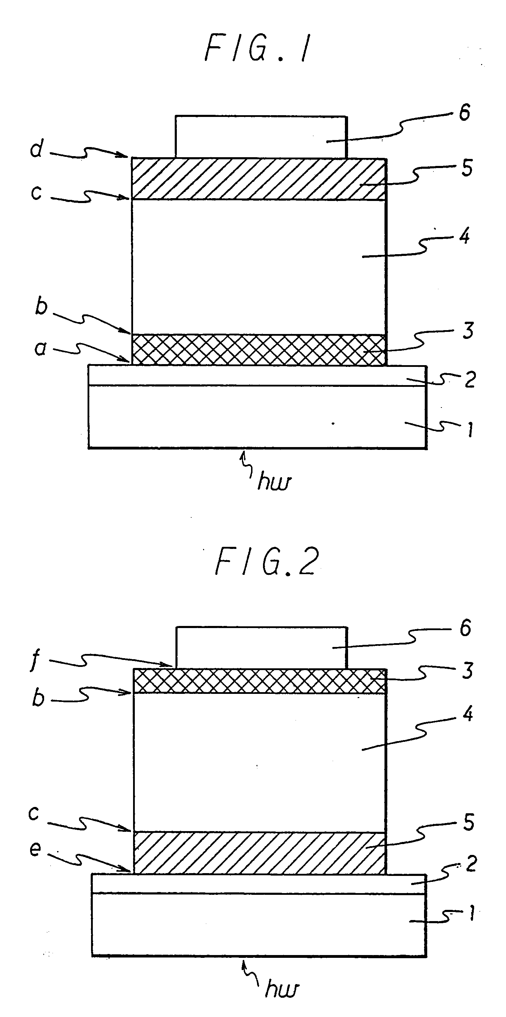

The interlayer, which has a higher electrical resistivity than the semiconductor layer adjoining the interlayer, can be formed at a junction interface (a) of a transparent electrode 2 and p-type layer 3 of pin-type semiconductor device shown in Fig. 1; a junction interface (b) of p-type layer 3 and i-type layer 4; a junction interface (c) of i-type layer 4 and n-type layer 5; a junction interface (d) of n-type layer 5 and a metal electrode 6; a junction interface (e) of n-type layer 5 and a transparent electrode 2 of nip-type semiconductor device shown in Fig. 2; a junction interface (f) of p-type layer 3 and a metal electrode 6; a junction interface (b) of p-type layer 3 and i-type layer 4; a junction interface (c) of i-type layer 4 and n-type layer 5; and a p-type or n-type layer. In the case of a semiconductor device shown in Fig. 1, it is preferable to form the interlayer at a junction interface (a) of a transparent electrode 2 and p-type layer 3, particularly junction interface (b) of p-type layer 3 and i-type layer 4 because such interfaces locate at the side of light incidence and thereby Voc can be further improved.

The thickness of the interlayer, which is formed between semiconductor layers or between a semiconductor layer and an electrode and comprises a semiconductor or insulator having higher electrical resistivity than a semiconductor layer which adjoins the interlayer, is 1-50nm (10 to 500 Å) preferably 1-20nm (10 to 200 Å) more preferably 1-10nm (10 to 100 Å). When the thickness of the interlayer is less than 1 nm (10 Å), the improvement of Voc is a little, and on the other hand when it is more than 500 Å, the reduction of curve factor becomes large.

In the semiconductor device of the present invention, the interlayer can be produced by glow discharge decomposition method, sputtering method, thermal CVD method, photo CVD method or the like, using such a device that has fundamentally pin-type or nip-type semiconductor layer such as single-type device, tandem-type device or integrated-type device. In the present invention, employable semiconductors are not particularly limited. That is, any semiconductor can be used as far as it comprises pin-type or nip-type semiconductor.

A semiconductor device of the present invention obtained by the above method is preferably used under a light source of low illuminance such as a fluorescent lamp in which series resistance does not seriously become a problem, because the semiconductor device of the present invention causes the increase of series resistance and thereby lowers a curve factor, or the like.

There can be obtained a semiconductor device having large Voc and electric current under a specific voltage like the above-mentioned device, in case of adding to an interlayer a very small amount of dopant to such an extent that the electric resistivity of the interlayer does not become smaller than a semiconductor layer which adjoins the interlayer.

Now, there are explained Examples and Comparative Examples with respect to the present invention, namely Examples 1 to 11 and Comparative Example 1.

### Examples 1 to 8

A glass substrate was obtained by depositing SnO₂ film of 0.1 µm thick on a glass plate of 1.1 mm thick by means of thermal CVD method.

The obtained glass substrate was heated up to 240°C to form thereon a p-type a-SiC:H layer of 15nm (150 Å) in thickness using a parallel-plate·capacitively-coupled type plasma CVD apparatus, whereinto 50 sccm of mixed gas of three types of 1000 ppm diborane, i.e. (A) diborane diluted with monosilane, (B) diborane diluted with methane and (C) diborane diluted with hydrogen (a flow ratio of (A), (B) and (C) is 1 : 3 : 1) was introduced and glow discharge decomposition was carried out with rf frequency of 13.56 MHz and rf power of 30 W.

About 20 atm % of carbon was contained in the obtained p-type a-SiC:H layer. The conductivity of the a-SiC:H layer was about 10⁻⁷ (Ω·cm)⁻¹.

After exhausting a residual mixed gas, a mixed gas consisting of 20 sccm of monosilane and 30 sccm of methane was introduced into the apparatus to form, without using doping gas, an interlayer comprising a-SiC of which thickness is shown in Table 1.

Next, after exhausting a residual mixed gas, 50 sccm of monosilane gas was introduced and glow discharge decomposition was carried out with rf frequency of 13.56 MHz and rf power of 30 W in the same manner as described above to form i-type a-Si:H layer of 700nm (7000 Å) in thickness. Then, glow discharge decomposition was carried out with rf having the same power as mentioned above, using 100 sccm of 1000 ppm phosphine gas diluted with 20 sccm of monosilane, and hydrogen, to form n-type a-Si:H film of 30nm (300 Å)in thickness.

Next, Aℓ was evaporated as a rear electrode using resistive-heating type vacuum evaporation apparatus to make a photoelectric converter.

In accordance with the same manner as described above, five photoelectric converters were further made. Voc and curve factor of six photoelectric converters were measured under a fluorescent lamp at an illuminance of 200 lux. The results are summarised in Table 1.

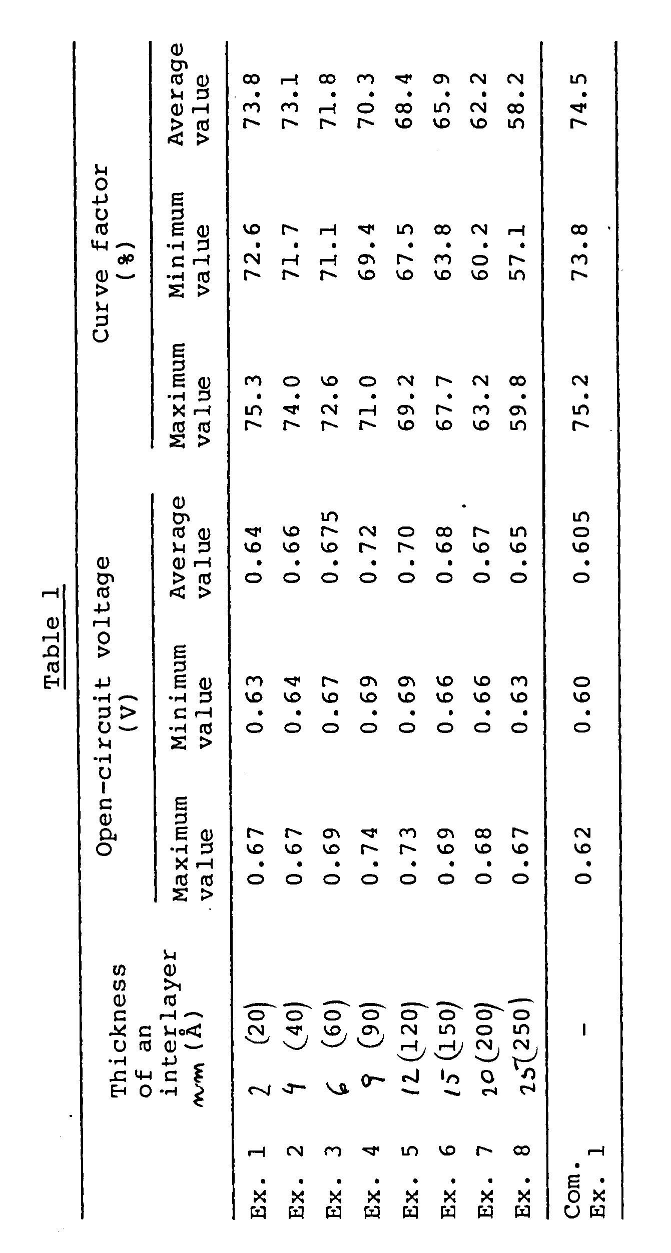

### Examples 9 to 11

The procedure of Example 4 was repeated except that interlayers were formed at a junction interface of a transparent electrode and a p-type layer (hereinafter referred to as TE/P) (Example 9); at a junction interface of an i-type layer and an n-type layer (hereinafter referred to as i/n) (Example 10); and at a junction interface of an n-type layer and Aℓ electrode (hereinafter referred to as n/Aℓ) (Example 11). Voc and curve factor were measured like in Examples 1 to 8. The results are summarized in Table 2.

Examples 9 and 11 are not part of the present invention.

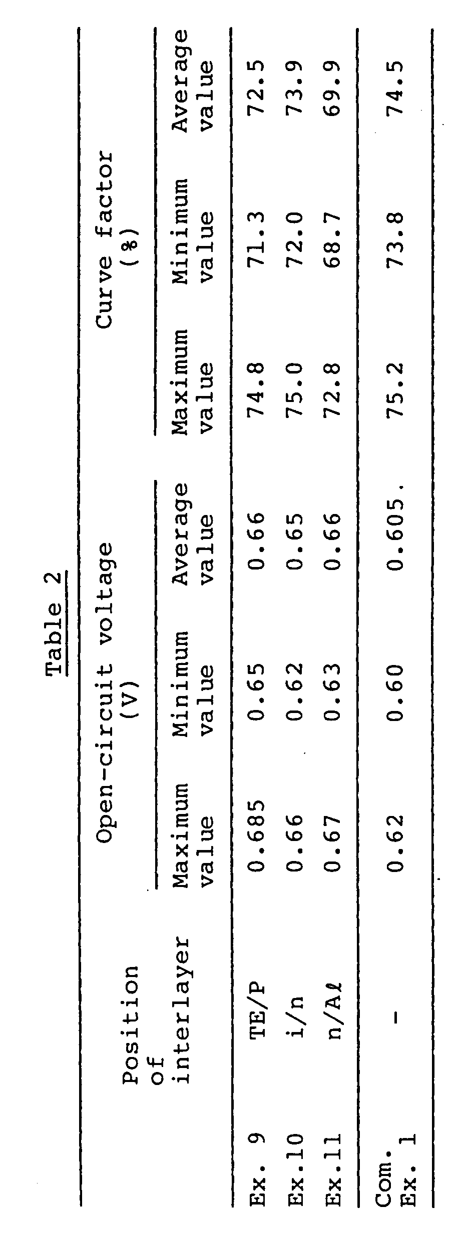

### Comparative Example 1

A glass substrate was obtained by depositing SnO₂ film of 0.1 µm thick on a glass plate of 1.1 mm thick by means of thermal CVD method.

The obtained glass substrate was heated up to 240°C to form thereon a p-type a-SiC:H layer of 15nm (150 Å) in thickness using a parallel-plate capacitively-coupled type plasma CVD apparatus, whereinto 50 sccm of mixed gas of three types of 1000 ppm diborane, i.e. (A) diborane diluted with monosilane, (B) diborane diluted with methane and (C) diborane diluted with hydrogen (a flow ratio of (A), (B) and (C) is 1 : 3 : 1) was introduced and glow discharge decomposition was carried out with rf frequency of 13.56 MHz and rf power of 30 W.

About 20 atom % of carbon was contained in the obtained p-type a-SiC:H layer. The conductivity of the a-SiC:H layer was about 10⁻⁷ (Ω·cm)⁻¹.

Next, after exhausting a residual mixed gas, 50 sccm of monosilane gas was introduced and glow discharge decomposition was carried out with rf frequency of 13.56 MHz and rf power of 30 W in the same manner as described above to form i-type a-Si:H layer of 700nm (7000 Å) in thickness. Then, glow discharge decomposition was carried out with rf having the same power as mentioned above, using 100 sccm of 1000 ppm phosphine gas diluted with 20 sccm of monosilane, and hydrogen, to form n-type a-Si:H film of 300 Å in thickness.

Next, Aℓ was evaporated as a rear electrode using resistive-heating type vacuum evaporation apparatus to make a photoelectric converter.

In accordance with the same manner as described above, five photoelectric converters were further made. Voc and curve factor of six photoelectric converters were measured under a fluorescent lamp at an illuminance of 200 lux. Voc was 0.60 to 0.62 V (0.606 V in average), and curve factor was 74.5 %. These results are summarised in Tables 1 and 2.

As is described in detail hereinbefore, the semiconductor device according to the present invention has larger Voc and electric current (working current) at a specific voltage than conventional devices, thereby it can preferably be used in consumer-use solar cells, particularly in such solar cells that are equipped with electrical and electric equipment used under low-illumination light source such as fluorescent lamp.

## Claims

1. A semiconductor device comprising at least one set of semiconductor layers, said set having a p-i-n structure wherein
(1) p represents a p-type semiconductor layer which is an at least partially amorphous material doped with a p-type dopant,
(2) i represents an intrinsic semiconductor layer which is an at least partially amorphous semicondutor material, and
(3) n represents an n-type semiconductor layer which is an at least partially amorphous semiconductor material doped with an n-type dopant,
said semiconductor device further comprising at least one electrode provided on the outer surface of the outermost p-type semiconductor layer and at least one electrode provided on the outer surface of the outermost n-type semiconductor layer,
wherein at least one interlayer having a thickness of 1 to 50 nm (10 to 500 Å) is interposed at at least one interface between two semiconductor layers of said p-i-n structure,
said interlayer being selected from the group consisting of Si₁₋ₓCₓ:X:Y and Si₁₋ₓOₓ:X:Y, wherein x satisfies the relationship 0<x<1, X is selected from the group consisting of H, Cl, F and Br, and Y is selected from the group consisting of H, Cl, F and Br, characterized in that said interlayer has a higher electrical resistivity than the adjacent semiconductor layers.

2. The device of claim 1, wherein the interlayer is Si₁₋ₓCₓ:H, wherein x satisfies the relationship 0<x<1.

## Patentansprüche

1. Halbleitereinrichtung, die umfaßt mindestens einen Satz von Halbleiterschichten, der eine p-i-n-Struktur hat, worin bedeuten
1) p eine Halbleiterschicht vom p-Typ, die aus einem mindestens teilweise amorphen Material besteht, das mit einem Dotierungsmittel vom p-Typ dotiert ist,
2) i eine Intrinsic-Halbleiterschicht, die aus einem mindestens teilweise amorphen Halbleitermaterial besteht, und
3) n eine Halbleiterschicht vom n-Typ, die aus einem mindestens teilweise amorphen Halbleitermaterial besteht, das mit einem Dotierungsmittel vom n-Typ dotiert ist,
wobei die Halbleiter-Einrichtung außerdem aufweist mindestens eine Elektrode, die auf der äußeren Oberfläche der äußersten Halbleiterschicht vom p-Typ vorgesehen ist, und mindestens eine Elektrode, die auf der äußeren Oberfläche der äußersten Halbleiterschicht vom n-Typ vorgesehen ist, wobei mindestens eine Zwischenschicht mit einer Dicke von 1 bis 50 nm (10-500 Å) angeordnet ist an mindestens einer Grenzfläche zwischen zwei Halbleiterschichten der genannten p-i-n-Struktur, wobei diese Zwischenschicht ausgewählt wird aus der Gruppe, die besteht aus Si₁₋ₓCₓ:X:Y und
Si₁₋ₓOₓ:X:Y, worin x der Beziehung 0 < x < 1 genügt; X ausgewählt wird aus der Gruppe, die besteht aus H, Cl, F und Br, und Y ausgewählt wird aus der Gruppe , die besteht aus H, Cl, F und Br,
dadurch gekennzeichnet, daß die Zwischenschicht einen höheren spezifischen elektrischen Widerstand hat als die angrenzenden Halbleiterschichten.

2. Einrichtung nach Anspruch 1, worin die Zwischenschicht aus Si₁₋ₓCₓ:H besteht, worin x der Beziehung 0 < x < 1 genügt.

## Revendications

1. Dispositif à semi-conducteur comprenànt au moins un jeu de couches semi-conductrices, ledit jeu ayant une structure p-i-n dans lequel:
(1) p représente une couche semi-conductrice de type p qui est un matériau au moins partiellement amorphe dopé avec un dopant de type p,
(2) i représente une couche semi-conductrice intrinsèque qui est un matériau semi-conducteur au moins partiellement amorphe, et
(3) n représente une couche semi-conductrice de type n qui est un matériau semi-conducteur au moins partiellement amorphe dopé avec un dopant de type n,
ledit dispositif à semi-conducteur comprenant en outre au moins une électrode placée sur la surface externe de la couche semi-conductrice de type p la plus externe et au moins une électrode placée sur la surface externe de la couche semi-conductrice de type n la plus externe,
dans lequel au moins une couche intermédiaire ayant une épaisseur de 1 à 50 nm (10 à 500 Å) est interposée sur au moins une interface entre deux couches semi-conductrices de ladite structure p-i-n, ladite couche intermédiaire étant sélectionnée à partir du groupe se composant de Si₁₋ₓCₓ:X:Y et de Si₁₋ₓOₓ:X:Y, dans lequel x satisfait la relation de 0<x<1, X est sélectionné à partir du groupe se composant de H, Cl, F et Br, et Y est sélectionné à partir du groupe se composant de H, Cl, F et Br, caractérisé en ce que ladite couche intermédiaire a une résistivité électrique plus élevée que les couches semi-conductrices voisines.

2. Dispositif selon la revendication 1, dans lequel la couche intermédiaire est du Si₁₋ₓCₓ:H, dans lequel x satisfait la relation de 0<x<1.
